# DEMANDE DE BREVET EUROPEEN

(11) **EP 4 491 758 A1**
(43) Date de publication de la demande: **15.01.2025**
(21) Numéro de dépôt: 24186759.7
(22) Date de dépôt: 05.07.2024
(51) Int. Cl.: C23C 14/00, C23C 14/02, C23C 14/04, C23C 14/06, C23C 14/08, C23C 14/20, C23C 14/54, B60K 37/00, B60K 37/20

(54) **PROCEDE D'APPLICATION D'UN DECOR METALLIQUE SUR UN SUBSTRAT DE PIECE AUTOMOBILE, PIECE AUTOMOBILE COMPORTANT UN DECOR METALLIQUE ET VEHICULE AUTOMOBILE COMPORTANT UNE TELLE PIECE**

(30) Priorité: 10.07.2023 FR 2307383
(71) Demandeur: Plastiques du Val de Loire, 37130 Langeais (FR)
(72) Inventeur: TOULIS, Anthony, 72600 MAMERS (FR); COMPOINT, François, 37130 Langeais (FR); HERSARD, Bruno, 37130 Langeais (FR)
(74) Mandataire: Ipside

(57) **Abrégé**

L'invention concerne un procédé (300) d'application d'un décor métallique sur un substrat (110) de pièce automobile (100), comprenant les étapes de :
- fournir un substrat (110) en matière plastique ;
- métalliser le substrat (110) par dépôt d'une couche métallique (120) réflective sur le substrat (110) ;
- former un dégradé interférentiel sur la pièce automobile (100), comprenant le dépôt PVD, dans une chambre (200) de dépôt, d'une couche transparente (130) interférentielle sur la couche métallique (120), ladite chambre (200) étant configurée de manière à ce qu'une partie visible de la pièce automobile (100) soit dans la ligne de vue directe d'une cible (210) de matériau de base, et une partie dite non-visible ne soit en permanence pas dans la ligne de vue directe, de sorte qu'une portion de dégradé (P) d'épaisseur variable de la couche transparente (130) est formée à la frontière entre les parties visible et non-visible.

## Description

### DOMAINE TECHNIQUE DE L'INVENTION

Le domaine de l'invention est celui des procédés d'obtention de pièces comportant des décors d'aspect métallique, ainsi que des pièces qui sont ainsi obtenues.

Plus précisément, l'invention concerne un procédé d'application d'un décor métallique sur un substrat de pièce automobile.

L'invention concerne également une pièce automobile comportant un décor métallique avec un dégradé interférentiel, ainsi qu'un véhicule automobile comportant une telle pièce.

L'invention trouve notamment des applications dans le domaine automobile, pour la réalisation de décors métalliques sur des substrats de pièces automobiles en matière plastique, par exemple des pièces décoratives de planche de bord automobile.

En particulier, l'invention trouve des applications pour réaliser des dégradés d'aspect coloré sur une pièce automobile, ou encore aéronautique ou nautique, métallisée.

L'invention peut toutefois également trouver des applications pour réaliser des pièces comportant des décors colorés dégradés dans d'autres domaines techniques, tel que les domaines des appareils électroménagers, de cuisine, électroniques, ou encore des contenants, notamment cosmétiques.

### ÉTAT DE LA TECHNIQUE

Il est connu de l'art antérieur des techniques de décoration de pièces plastiques, notamment pour véhicules automobiles.

Parmi ces techniques, on connaît des procédés de métallisation de pièces plastiques.

La métallisation de pièces plastiques, en particulier dans le domaine automobile, permet d'obtenir des pièces d'aspect particulièrement esthétique et procurant un aspect « haut de gamme ».

De plus, les pièces de ce type sont de faible poids en raison de leur substrat de base en matière plastique, finement revêtu de métal, et sont beaucoup plus légères qu'une pièce métallisée en matière pleine.

Les pièces de ce type sont également particulièrement économiques, pouvant être réalisées par des procédés classiques de fabrication de pièces plastiques (par exemple, par moulage par injection de matière plastique), puis être métallisées en tout ou partie selon leur destination (c'est-à-dire, notamment dans le domaine automobile, selon la gamme, et/ou la finition, et/ou les options du véhicule).

Lorsque cela est souhaité, les pièces métallisées obtenues par ces procédés peuvent être teintées par exemple au moyen de l'application d'un vernis coloré translucide, afin d'obtenir un aspect métallisé coloré.

Cependant, les techniques connues de coloration possèdent plusieurs inconvénients.

Tout d'abord, la coloration pouvant être obtenue de cette manière ne peut être qu'uniforme sur toute la pièce, ou du moins sur les zones sur lesquelles le vernis est appliqué.

Ainsi, ces techniques ne permettent pas d'obtenir de variations de couleurs sur une même pièce, et ne permettent au mieux qu'une variation abrupte de la teinte de la pièce entre deux zones de la pièce automobile.

En particulier, l'obtention de dégradés colorés n'est pas possible au moyen de telles techniques.

De plus, ces techniques nécessitent l'utilisation de pigments incorporés au vernis, ce qui nécessite une préparation spécifique desdits pigments pour chaque teinte de vernis souhaitée. Le coût économique ainsi que le coût écologique, c'est-à-dire leur « bilan carbone », est en outre élevé. L'utilisation de certains pigments peut également s'avérer désavantageuse d'un point de vue environnemental, en raison de leur toxicité.

Ainsi, il existe un besoin d'amélioration des décors métalliques pouvant être obtenus sur une pièce automobile, qui soit particulièrement économique, commode et simple.

### EXPOSÉ DE L'INVENTION

La présente invention vise à remédier à tout ou partie des inconvénients de l'état de la technique cités ci-dessus.

À cet effet, l'invention vise un procédé d'application d'un décor métallique sur un substrat de pièce automobile en matière plastique, comprenant les étapes de :
- fournir un substrat de pièce automobile en matière plastique ;
- métalliser au moins partiellement le substrat par dépôt d'au moins une couche métallique dite réflective sur tout ou partie du substrat ;

Le procédé comprend en outre l'étape de :
- former un dégradé interférentiel sur la pièce automobile, comprenant le dépôt physique en phase vapeur, dans une chambre de dépôt physique en phase vapeur, d'une couche transparente dite interférentielle sur tout ou partie de l'au moins une couche métallique réflective, ladite chambre étant configurée de manière à ce qu'une partie dite visible de la pièce automobile soit dans la ligne de vue directe d'une cible de matériau de base à déposer en phase vapeur, et une partie dite non-visible de la pièce automobile ne soit en permanence pas dans la ligne de vue directe de ladite cible, de sorte que ladite partie visible est revêtue d'une épaisseur de couche transparente interférentielle et ladite partie non-visible n'est pas revêtue de couche transparente interférentielle, et une portion dite de dégradé d'épaisseur variable de la couche transparente interférentielle est formée à la frontière entre ladite partie visible et ladite partie non-visible.

Grâce à cela, le décor métallique comporte un dégradé interférentiel qui présente un aspect coloré lorsque le décor métallique est exposé à la lumière.

On précise que l'aspect coloré peut varier en coloration et en intensité notamment selon l'intensité de l'exposition à la lumière, et/ou l'angle incident de la lumière, et/ou l'angle d'observation du décor, et/ou la nature de la source de lumière qui peut notamment être naturelle ou artificielle.

On précise également que les termes « couche transparente » comprend les couches transparentes ayant une transmission lumineuse proche de 100%, mais également des couches transparentes ayant une transmission lumineuse différente de 100%. Autrement dit, ces termes englobent également les couches semitransparentes. En effet, il importe que la couche transparente puisse transmettre la lumière pour obtenir des effets lumineux interférentiels, et pour que la couche métallique soit visible sous la couche transparente afin de procurer l'aspect métallique au décor.

De plus, la couche transparente peut être teintée, et par exemple comporter une coloration légèrement brune ou grise. Une telle coloration peut notamment être produite par les composés chimiques de la couche transparente.

Un tel procédé permet l'obtention d'un décor métallique comportant un dégradé interférentiel sur une pièce automobile de manière particulièrement simple, commode et économique.

Dans le procédé, c'est la configuration particulière de la chambre de dépôt physique en phase vapeur qui permet l'obtention d'une portion de dégradé d'épaisseur variable, sans qu'il ne soit nécessaire de contrôler le dépôt de matière en tant que tel.

En d'autres termes, il est possible de procéder au dépôt physique en phase vapeur (PVD) de manière similaire à un dépôt PVD classique destiné à recouvrir l'intégralité d'une pièce d'une couche uniforme de matériau, tout en obtenant une couche présentant des zones d'épaisseur différentes à des endroits prédéterminés de la pièce automobile.

L'obtention de telles zones d'épaisseur différente de la couche interférentielle induit des effets d'optiques, à savoir des effets interférentiels plus ou moins iridescents, dont il résulte un aspect coloré de la pièce métallique.

En particulier, sur la portion de dégradé, un dégradé coloré est obtenu en raison de l'épaisseur variable de la couche transparente interférentielle sur cette portion.

On précise ici qu'aucun pigment ou colorant n'est nécessaire pour l'obtention d'un aspect coloré, qui est uniquement dû à des interférences induites par la couche transparente interférentielle.

Ainsi, le procédé est également particulièrement respectueux de l'environnement, une simple couche fine de matériau transparent étant suffisante pour l'obtention de l'effet coloré.

L'aspect des couleurs au niveau de la couche interférentielle peut être contrôlé au moyen du contrôle de paramètres du procédé de dépôt PVD directement (tel que la puissance de pulvérisation et le temps de pulvérisation, le type de gaz réactif utilisé le cas échéant, etc.).

Enfin, le procédé est particulièrement économique en ce qu'il peut être mis en oeuvre avec des outils de production préexistants et non spécifiques au procédé (une chambre de dépôt PVD notamment), et une grande variété d'effets colorés pouvant être obtenu par un simple contrôle de paramètres de dépôt PVD.

D'autres caractéristiques particulièrement simples et commodes du procédé selon l'invention sont décrites ci-après.

Préférentiellement, dans le procédé, la chambre de dépôt physique en phase vapeur est configurée avec un masque qui est disposé à distance de la pièce automobile entre la cible et la pièce automobile, le masque étant placé en vis-à-vis de ladite partie non-visible, et au moins un bord du masque étant placé en vis-à-vis de pièce automobile, de façon à former ladite portion de dégradé sur la pièce automobile en vis-à-vis dudit bord du masque.

Une telle configuration de la chambre de dépôt PVD permet un contrôle particulièrement précis de l'emplacement, la forme et la taille de la portion de dégradé.

Il est également particulièrement simple de configurer une chambre de dépôt PVD avec la disposition d'un masque à l'intérieur, le procédé pouvant ainsi être mis en oeuvre sur des outils de productions préexistants sans modifications complexes.

Préférentiellement, dans le procédé, le masque est disposé à une distance prédéterminée de la pièce automobile, cette distance prédéterminée déterminant la dimension de ladite portion de dégradé dans au moins une direction de dégradé s'étendant entre la partie visible et la partie non-visible.

Ainsi, il est possible d'ajuster précisément la taille de la portion de dégradé en ajustant la position du masque uniquement, sans toutefois nécessiter de modification d'autres paramètres du procédé, notamment de paramètres de dépôt PVD.

Préférentiellement, dans le procédé, l'au moins un bord du masque placé en vis-à-vis de pièce automobile forme un contour d'un motif prédéterminé, de manière à former le négatif dudit motif sur la pièce automobile par dépôt de la couche transparente interférentielle.

Ainsi, il est possible d'obtenir une portion de dégradé formant un motif particulièrement esthétique, ou de former un logo, un élément indicateur (une flèche par exemple) ou tout autre forme souhaitée, uniquement en fournissant un masque présentant un contour d'un tel motif.

Préférentiellement, alternativement dans le procédé, la chambre de dépôt physique en phase vapeur est configurée avec la pièce automobile qui est disposée dans la chambre de dépôt physique en phase vapeur de sorte que la partie visible soit orientée vers la cible et la partie non-visible soit orientée en éloignement de la cible.

Une telle configuration de la chambre de dépôt PVD permet d'obtenir un décor avec une portion de dégradé sans nécessiter d'élément additionnel dans la chambre de dépôt PVD, uniquement au moyen d'une disposition particulière de la pièce automobile dans la chambre de dépôt PVD.

Préférentiellement, dans le procédé, la pièce automobile est disposée à une distance prédéterminée de la cible et/ou avec une orientation prédéterminée par rapport à la cible, cette distance prédéterminée et/ou orientation prédéterminée déterminant la dimension de la portion de dégradé dans au moins une direction de dégradé s'étendant entre la partie visible et la partie non-visible.

Ainsi, il est possible d'ajuster précisément la taille de la portion de dégradé en ajustant la position de la pièce automobile uniquement, sans toutefois nécessiter de modification d'autres paramètres du procédé, notamment de paramètres de dépôt PVD.

Préférentiellement, dans le procédé, lors de l'étape de former un dégradé interférentiel, la couche transparente interférentielle est déposée sur une épaisseur prédéterminée au niveau de la partie visible, cette épaisseur prédéterminée déterminant la couleur perçue par interférence optique au niveau de la partie visible ainsi qu'au niveau de la portion de dégradé.

Ainsi, il est possible de faire varier la couleur perçue au niveau du décor interférentiel simplement en contrôlant l'épaisseur de la couche transparente interférentielle déposée au niveau de la partie visible.

Par exemple, l'épaisseur de la couche transparente interférentielle déposée au niveau de la partie visible peut être contrôlée par l'intermédiaire du contrôle de la durée de dépôt PVD.

Préférentiellement, dans le procédé, lors de l'étape de former un dégradé interférentiel, le matériau de base à déposer est choisi parmi le titane (Ti), le zirconium (Zr), le chrome (Cr), le silicium (Si), le cuivre (Cu), l'aluminium (Al), le nickel (Ni), le magnésium (Mg), le tantale (Ta), le hafnium (Hf) ou le carbone type diamant (DLC).

De tels matériaux ont pour propriété d'être particulièrement adaptés pour former une couche transparente interférentielle, avec un effet plus ou moins iridescent.

Préférentiellement, dans le procédé, le dépôt physique en phase vapeur est de type pulvérisation cathodique, préférentiellement de type pulvérisation cathodique magnétron.

Ce type de technique de dépôt PVD dit « pulvérisation cathodique » permet une maîtrise particulièrement satisfaisante du procédé, notamment en ce qui regarde la maîtrise de l'empoisonnement de la cible de matériau de base à déposer et la maîtrise des couleurs apparaissant au niveau de la portion de dégradé. De plus, les temps de cycle de fabrication sont réduits, ce qui est particulièrement avantageux dans le cadre d'une production industrielle. En outre, cette technique permet une bonne répétabilité des couleurs ou teintes colorées métalliques du décor métallique.

Préférentiellement, dans le procédé le dépôt physique en phase vapeur est un dépôt physique en phase vapeur dit réactif, réalisé en présence d'une quantité prédéterminée de gaz réactif et d'une quantité prédéterminée de gaz porteur, permettant d'obtenir une couche transparente interférentielle de stoechiométrie prédéterminée déterminant la couleur perçue au niveau de la partie visible.

Ce type de technique de dépôt PVD dit « réactif » permet une maîtrise particulièrement satisfaisante du procédé, notamment en ce qui regarde la maîtrise de l'empoisonnement de la cible de matériau de base à déposer et la maîtrise des couleurs apparaissant au niveau de la portion de dégradé. De plus, les temps de cycle de fabrication sont réduits, ce qui est particulièrement avantageux dans le cadre d'une production industrielle. En outre, cette technique permet une bonne répétabilité des couleurs ou teintes colorées métalliques du décor métallique.

Préférentiellement, dans le procédé, le gaz réactif est du dioxygène (O2) ou du diazote (N2).

De tels gaz ont pour propriété d'être particulièrement adaptés pour former une couche transparente interférentielle avec le matériau de base à déposer.

De plus, de tels gaz sont dépourvus de toxicité et ne sont pas carbonés, contribuant à réduire l'impact environnemental du procédé.

Préférentiellement, dans le procédé, l'étape de métalliser le substrat est réalisé par dépôt physique en phase vapeur ou par métallisation galvanique.

Un tel type de dépôt permet de déposer une couche mince métallique (par exemple chromée) de manière particulièrement simple et économique.

Il convient de préciser que l'ensemble des choix relatifs au matériau de base à déposer, et/ou du gaz réactif, et/ou la stoechiométrie de la couche transparente interférentielle, et/ou du matériau de la couche métallique ont une incidence sur la couleur perçue par interférence, chaque combinaison de ces paramètres formant un système interférentiel différent, et qui a pour résultat un effet interférentielle iridescent différent.

Le contrôle d'un ou plusieurs de ces paramètres permet ainsi de varier librement l'aspect coloré de la pièce automobile.

Préférentiellement, le procédé comprend en outre l'étape de :
- déposer une couche de base sur tout ou partie du substrat en matière plastique, préalablement à l'étape de métalliser le substrat ;

la couche de base étant sélectionnée de sorte à promouvoir l'adhérence de l'au moins une couche métallique réflective sur le substrat ; et/ou l'étape de :
   - déposer une couche de finition transparente sur tout ou partie de la pièce automobile, suite à l'étape de former un dégradé interférentiel,
la couche de finition étant sélectionnée avec un indice de réfraction sensiblement équivalent à l'indice de réfraction de la couche transparente interférentielle.

La couche de base peut permettre à promouvoir l'adhérence de l'au moins une couche métallique réflective mais également de masquer d'éventuels défauts de surface du substrat, et éventuellement de modifier l'iridescence de la couche transparente interférentielle.

La couche de finition peut servir à protéger le décor métallique. Elle peut également servir à procurer un aspect mat, satin ou brillant selon la composition choisie de la couche de finition.

La couche de finition est choisie de sorte à préserver l'effet interférentiel sans le modifier, c'est-à-dire sans interférer avec la lumière réfléchie au niveau de la couche transparente interférentielle.

L'invention a aussi pour objet, sous un deuxième aspect, une pièce automobile comportant un décor métallique avec un dégradé interférentiel, comprenant :
- un substrat en matière plastique ;
- au moins une couche métallique dite réflective déposée, c'est-à-dire disposée, sur au moins une partie du substrat ;

La pièce automobile comprend en outre :
- une couche transparente dite interférentielle déposée, c'est-à-dire disposée, sur tout ou partie de l'au moins une couche métallique réflective ; la couche transparente interférentielle comportant une zone d'épaisseur supérieure, une zone d'épaisseur réduite ou nulle de la couche transparente interférentielle, et une portion dite de dégradé sur laquelle l'épaisseur de la couche transparente interférentielle décroit strictement selon au moins une direction de dégradé, depuis la zone d'épaisseur supérieure jusqu'à la zone d'épaisseur réduite ou nulle de la couche transparente interférentielle.

Grâce à cela, le décor métallique comporte un dégradé interférentiel qui présente un aspect coloré lorsque le décor métallique est exposé à la lumière.

Une telle pièce automobile présente un décor métallique coloré obtenu uniquement par effet optique d'interférence, sans nécessiter de pigments ou colorants.

Une telle pièce est susceptible d'être obtenue de manière particulièrement simple et commode, seule l'épaisseur de la couche transparente interférentielle devant être déposée de façon contrôlée localement, par exemple comme décrit ci-avant.

D'autres caractéristiques particulièrement simples et commodes de la pièce automobile selon l'invention sont décrites ci-après.

Préférentiellement, dans la pièce automobile, la couche transparente interférentielle est une couche mince de dioxyde de titane (TiO2), de dioxyde de zirconium (ZrO2), de dioxyde de chrome (CrO2), de nitrure de silicium (Si3N4), de carbone type diamant (DLC), de nitrure de titane (TiN), d'oxynitrure de titane (TiNxOy), ou de silicium (Si).

Préférentiellement, dans la pièce automobile, la couche métallique est une couche mince comprenant du chrome, et/ou de l'aluminium, et/ou du titane

Préférentiellement, dans la pièce automobile, le substrat en matière plastique est en polycarbonate (PC), en polypropylène (PP), en acrylonitrile butadiène styrène (ABS) ou en mélange polycarbonate-acrylonitrile butadiène styrène (PC-ABS).

Dans la pièce automobile, l'épaisseur de la zone d'épaisseur supérieure de la couche transparente interférentielle est comprise entre 10 et 400 nanomètres, préférentiellement comprise entre 10 et 300 nanomètres, et encore plus préférentiellement comprise entre 10 et 100 nanomètres.

L'invention a aussi pour objet, sous un troisième aspect, un véhicule automobile comprenant une pièce automobile telle que décrite ci-avant.

### BRÈVE DESCRIPTION DES FIGURES

D'autres avantages, buts et caractéristiques particulières de la présente invention ressortiront de la description non limitative qui suit d'au moins un mode de réalisation particulier des dispositifs et procédés objets de la présente invention, en regard des dessins annexés, dans lesquels :
- la figure 1 représente une pièce automobile, qui est ici une baguette décorative de tableau de bord automobile, comportant un décor métallique interférentiel ;
- la figure 2 est une schématique et en vue en coupe transversale d'une pièce automobile comportant un décor métallique interférentiel ;
- la figure 3 est similaire à la figure 2, la pièce automobile comportant en outre une couche de base et une couche de finition ;
- la figure 4 est un logigramme du procédé d'application d'un décor métallique sur un substrat de pièce automobile selon l'invention ;
- la figure 5 est un logigramme du procédé d'application d'un décor métallique sur un substrat de pièce automobile selon un premier mode de réalisation préférentiel comprenant la disposition d'un masque dans la chambre de dépôt PVD ;
- les figure 6, figure 7 et figure 8 représentent schématiquement une chambre de dépôt PVD configurée avec un masque disposé entre la pièce automobile et la cible, à différentes distances de la pièce automobile, illustrant la chambre de dépôt au cours du procédé d'application selon un premier mode de réalisation préférentiel ;
- la figure 9 est un logigramme du procédé d'application d'un décor métallique sur un substrat de pièce automobile selon un deuxième mode de réalisation préférentiel comprenant une disposition de la pièce automobile face à la cible
- les figure 10, figure 11 et figure 12 représentent schématiquement une chambre de dépôt PVD configurée avec la pièce automobile disposée face à la cible, à différentes distances de la cible, illustrant la chambre de dépôt au cours du procédé d'application selon un deuxième mode de réalisation préférentiel ;
- la figure 13 est similaire aux figures 10 à 12, mais sur laquelle la pièce automobile est pivotée d'un angle prédéterminé et possède ainsi une orientation différente des figures 10 à 12.

### DESCRIPTION DÉTAILLÉE DE L'INVENTION

La présente description est donnée à titre non limitatif, chaque caractéristique d'un mode de réalisation pouvant être combinée à toute autre caractéristique de tout autre mode de réalisation de manière avantageuse.

On note, dès à présent, que les figures ne sont pas nécessairement à l'échelle.

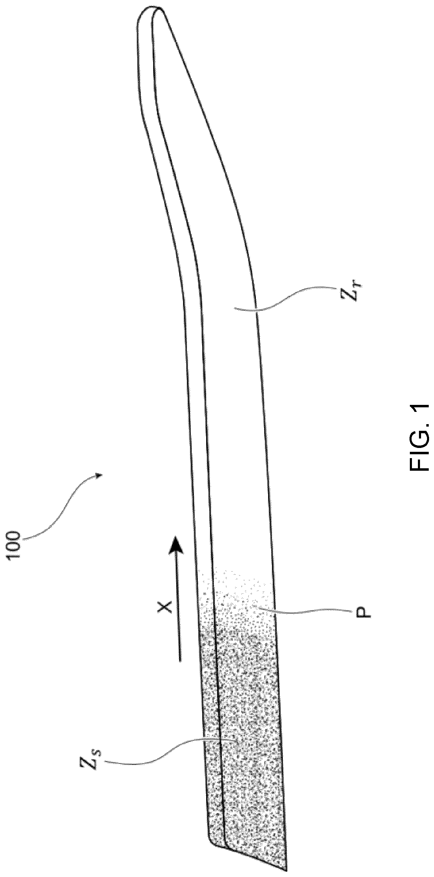

La figure 1 représente une pièce automobile 100 décorée, qui est ici une baguette décorative de planche de bord automobile.

La pièce automobile 100 représentée est ici une pièce en matière plastique métallisée, c'est-à-dire qu'elle comprend un substrat 110 en matière plastique et au moins une, et ici une seule, couche métallique 120 qui recouvre au moins partiellement le substrat 110.

Le substrat 110 est par exemple en polycarbonate (PC), en polypropylène (PP), en acrylonitrile butadiène styrène (ABS) ou en mélange polycarbonate-acrylonitrile butadiène styrène (PC-ABS).

Ici, toutes les faces de la pièce automobile 100 visibles sur la figure 1 sont métallisées, c'est-à-dire qu'elles sont recouvertes de la couche métallique 120, le substrat 110 en tant que tel n'étant pas visible sur la figure 1.

La face arrière de la pièce automobile 100, c'est-à-dire ici la face non visible sur la figure 1, peut quant à elle être métallisée ou non.

La pièce automobile 100 comporte en outre une couche transparente ou semi-transparente 130 interférentielle, ci-après appelée couche transparente 130, recouvrant en partie la couche métallique 120.

Sur la pièce automobile 100 représentée, la couche transparente 130 interférentielle présente une zone d'épaisseur supérieure *Zₛ*, sur laquelle la couche transparente 130 interférentielle est préférentiellement d'épaisseur sensiblement constante.

Par ailleurs, la couche transparente 130 interférentielle présente une zone d'épaisseur réduite *Zᵣ*, sur laquelle la couche transparente 130 interférentielle est préférentiellement également d'épaisseur sensiblement constante, mais inférieure à l'épaisseur au niveau de la zone d'épaisseur supérieure *Zₛ*.

La zone d'épaisseur réduite *Zᵣ* peut également être une zone d'épaisseur nulle *Zᵣ*, comme c'est le cas dans l'exemple illustré à la figure 1.

En d'autres termes, sur la zone d'épaisseur réduite ou nulle Z, représentée sur la figure 1, aucune couche interférentielle n'est appliquée, et la couche métallique 120 n'est ainsi par recouverte de couche interférentielle sur cette zone.

Ainsi, cette zone est désignée « zone d'épaisseur réduite ou nulle » *Zᵣ* dans la suite du présent mémoire, étant entendu que l'épaisseur est soit réduite, soit nulle selon l'application envisagée.

En outre, la pièce automobile 100 peut comprendre plusieurs zones d'épaisseur réduite ou nulle *Zᵣ*, qui peuvent chacune être d'épaisseur réduite ou nulle, et ne sont pas nécessairement toutes du même type.

Il convient également de préciser que l'une ou l'autre des zones d'épaisseur réduite ou nulle Z, et zone d'épaisseur supérieure *Zₛ* peut plus généralement être une surface, une ligne ou un point sur la pièce automobile 100.

La couche transparente 130 interférentielle présente en outre une portion dite de dégradé P entre la zone d'épaisseur supérieure *Zₛ* et la zone d'épaisseur réduite ou nulle *Zᵣ*.

L'épaisseur de la couche transparente 130 interférentielle sur la portion de dégradé P est variable dans une direction dite de dégradé X s'étendant entre la zone d'épaisseur supérieure *Zₛ* à la zone d'épaisseur réduite ou nulle *Zᵣ*.

En particulier, l'épaisseur de la couche transparente 130 interférentielle sur la portion de dégradé P décroît depuis la zone d'épaisseur supérieure *Zₛ* vers la zone d'épaisseur réduite ou nulle *Zᵣ*, dans la direction de dégradé X.

Préférentiellement, la décroissance de l'épaisseur de la couche transparente 130 interférentielle sur la portion de dégradé P est stricte.

L'épaisseur de la couche transparente 130 interférentielle sur la portion de dégradé P peut par exemple décroitre sensiblement linéairement depuis la zone d'épaisseur supérieure *Zₛ* vers la zone d'épaisseur réduite ou nulle *Zᵣ*, dans la direction de dégradé X.

Par décroissance stricte, on entend le fait que le profil d'épaisseur de la couche transparente 130 interférentielle sur la portion de dégradé P, selon la direction de dégradé X, suit une courbe de tendance strictement décroissante, la couche transparente 130 interférentielle pouvant toutefois localement présenter de faibles variations d'épaisseur et présenter un profil d'épaisseur qui n'est pas strictement monotone.

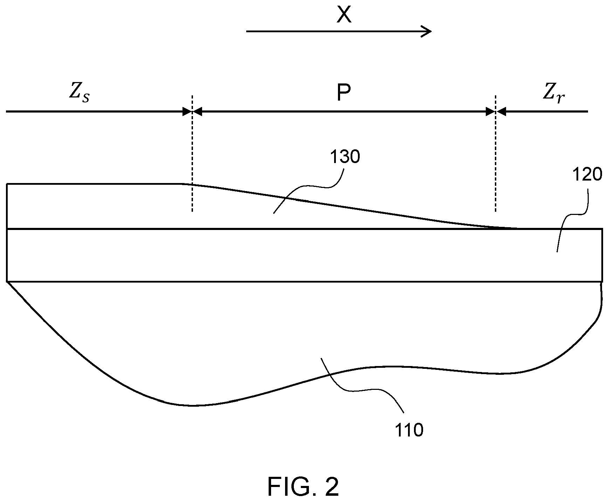

La figure 2 illustre schématiquement la pièce automobile 100 au niveau de la portion de dégradé P, selon une vue en coupe à travers la pièce automobile 100. Sur l'exemple illustré, l'épaisseur de la couche transparente 130 interférentielle sur la portion de dégradé P décroit sensiblement linéairement.

Au niveau de la zone d'épaisseur supérieure *Zₛ*, l'aspect de la pièce automobile 100 est métallique et coloré, la couleur étant sensiblement mono-chromique.

Par exemple, l'aspect de la pièce automobile 100 au niveau de la zone d'épaisseur supérieure *Zₛ* est bleu métallique.

Comme il est décrit par la suite, la couleur perçue au niveau de zone d'épaisseur supérieure *Zᵣ* peut être contrôlée, de différentes façons.

Au niveau de la zone d'épaisseur réduite ou nulle *Zᵣ*, qui est ici une zone d'épaisseur nulle *Zᵣ*, l'aspect de la pièce automobile 100 est ici métallique uniquement, sans couleur additionnelle perçue.

Toutefois, si sur cette zone l'épaisseur de la couche transparente 130 interférentielle est non-nulle, c'est-à-dire qu'il s'agit d'une zone d'épaisseur réduite *Zᵣ*, l'aspect peut être métallique et coloré, en étant sensiblement mono-chromique, par exemple l'aspect peut être jaune métallique.

Au niveau de la portion de dégradé P, l'aspect de la pièce automobile 100 est également métallique et coloré, avec un dégradé polychromique s'étendant depuis la zone d'épaisseur supérieure *Zₛ* vers la zone d'épaisseur réduite ou nulle *Zᵣ*, selon la direction de dégradé X.

Par exemple, le dégradé polychromique est un dégradé allant du bleu vers le jaune, en passant par le violet, le rouge et l'orange.

Il convient de préciser que l'aspect coloré de la pièce automobile 100 ne provient pas de pigments qui seraient présents dans l'une ou l'autre des couches métallique 120 ou transparente interférentielle 130. La couche métallique 120 est une couche sensiblement purement métallique, tandis que la couche transparente 130 interférentielle est une couche transparente ne comprenant aucun pigment colorant. L'aspect coloré de la pièce automobile 100 est obtenu uniquement par un effet optique interférentiel, qui est décrit plus en détail ci-après.

Dans l'exemple illustré aux figures 1 et 2, la lumière parvenant à la zone d'épaisseur réduite ou nulle *Zᵣ* est réfléchie au niveau de la couche métallique 120. Ici, la majeure partie de la lumière est réfléchie dans toutes ses longueurs d'onde (en considérant une lumière incidente polychromique) sauf celles absorbées par la couche métallique 120, ce qui résulte en l'aspect métallique de cette zone.

La lumière parvenant à la zone d'épaisseur supérieure *Zₛ* est réfléchie au niveau de la couche transparente 130 interférentielle, mais également au niveau de la couche métallique 120, en raison de la transparence de la couche transparente 130 interférentielle. En raison de la nature interférentielle de la couche transparente 130 interférentielle, c'est-à-dire en raison du fait que son indice de réfraction est différent de celui de l'air, la lumière parvenant à l'œil d'un observateur comprend des longueurs d'ondes dont l'intensité sera faible ou nulle, et d'autres longueurs d'ondes dont l'intensité sera amplifiée, en raison d'interférences destructives et/ou constructives de la lumière, résultant en un aspect coloré de la zone d'épaisseur supérieure *Zₛ*.

La couleur perçue par un observateur correspond à celle dont les longueurs d'ondes font l'objet d'une interférence constructive.

La couleur perçue par un observateur dépend de l'épaisseur de la couche transparente 130 interférentielle, mais également de l'angle d'observation, notamment.

Comme il sera décrit par la suite, la « stabilité » de la couleur perçue selon l'angle d'observation peut être contrôlé par l'intermédiaire de différents paramètres.

La variation de l'épaisseur de la couche transparente 130 interférentielle au niveau de la portion de dégradé P est à l'origine des différentes couleurs perçues par un observateur, en raison de la variation des longueurs d'onde faisant l'objet d'une interférence constructive sur cette portion (cette variation dépendant directement de l'épaisseur de la couche transparente 130 interférentielle).

Il en résulte un aspect de dégradé de couleur sur la portion de dégradé P, dans le sens qu'il s'agit d'une transition progressive d'une couleur (d'une couleur perçue ; on rappelle que ni la couche métallique 120 ni la couche transparente 130 interférentielle ne sont colorées en tant que telles) vers une autre.

Il convient de préciser que les couleurs apparaissant par effet interférentiel, ainsi que leur « ordre » d'apparition, sont entièrement déterminés par les lois de l'optique. Il s'agit ainsi d'un dégradé de couleur pouvant apparaître de façon analogue sur des structures de type « bulle de savon ».

Ce dégradé coloré est en outre iridescent, c'est-à-dire que les couleurs perçues du dégradé varient selon l'angle d'observation, de façon plus ou moins importante selon la composition de la couche transparente 130 interférentielle.

L'aspect général de la pièce automobile 100 qui en résulte est particulièrement esthétique et distinctif en comparaison avec les pièces automobiles métallisées connues.

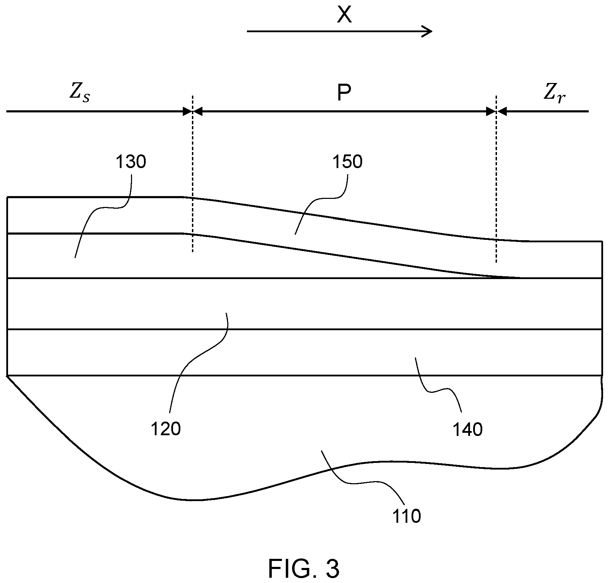

De façon optionnelle, tel qu'illustré sur la figure 3, la pièce automobile 100 peut comprendre une couche de base 140 appliquée sur tout ou partie du substrat 110, et sur laquelle est appliquée la couche métallique 120.

De préférence, la couche de base 140 est sélectionnée de sorte à promouvoir l'adhérence de la couche métallique 120 réflective sur le substrat 110, et/ou à masquer des défauts de surface du substrat 110 le cas échéant.

De façon optionnelle également, tel qu'illustré sur la figure 3, la pièce automobile 100 peut comprendre une couche de finition 150 transparente appliquée sur tout ou partie de la pièce automobile 100, sur la couche transparente 130 interférentielle et la couche métallique 120.

De préférence, la couche de finition 150 est choisie de façon à préserver les couleurs interférentielles perçues, c'est-à-dire qu'elle est sélectionnée avec un indice de réfraction sensiblement équivalent à l'indice de réfraction de la couche transparente 130 interférentielle. En outre, la couche de finition 150 est choisie de telle sorte qu'elle absorbe peu la lumière, et qu'elle réfléchisse peu la lumière au niveau de son interface avec l'air environnant.

A titre d'exemple, la couche de base 140 peut avoir une épaisseur comprise entre 15 et 25 micromètres, et préférentiellement comprise entre 10 et 25 micromètres.

La couche métallique 120 peut avoir une épaisseur comprise entre 80 à 150 nanomètres, et préférentiellement comprise entre 50 et 150 nanomètres.

La couche transparente 130 interférentielle peut avoir une épaisseur comprise entre 10 et 400 nanomètres, et préférentiellement comprise entre 10 et 300 nanomètres, et encore plus préférentiellement comprise entre 10 et 100 nanomètres.

La couche de finition peut avoir une épaisseur comprise entre 5 et 20 micromètres, et préférentiellement comprise entre 7 et 15 micromètres.

La dimension de la portion de dégradé P dans la direction de dégradé X peut par exemple être comprise entre 5 et 200 mm.

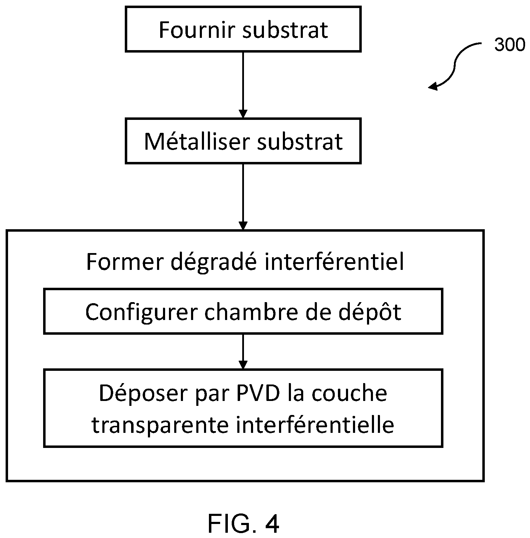

Il va maintenant être décrit un procédé 300 d'application d'un décor métallique comportant un dégradé interférentiel sur un substrat 110 de pièce automobile 100 en matière plastique, illustré par le logigramme de la figure 4.

La pièce automobile 100 décorée décrite ci-avant peut notamment être obtenue au moyen d'un tel procédé 300.

Le procédé 300 comprend l'étape de fournir un substrat 110 de pièce automobile 100 en matière plastique.

Par exemple, le substrat 110 peut être fabriqué par moulage par injection de matière plastique tel que le polycarbonate (PC), le polypropylène (PP) ou un mélange polycarbonate-acrylonitrile butadiène styrène (PC-ABS).

Optionnellement, le substrat 110 peut être préparé pour la métallisation, le procédé 300 comprenant alors une étape de déposer une couche de base 140 surtout ou partie du substrat 110 en matière plastique,

Comme évoqué ci-avant, la couche de base 140 est notamment sélectionnée de sorte à promouvoir l'adhérence d'au moins une couche métallique 120 réflective sur le substrat 110, appliquée lors de l'étape suivante dans le procédé 300.

Le procédé 300 comprend ensuite l'étape de métalliser au moins partiellement le substrat 110 par dépôt d'au moins une couche métallique 120 dite réflective sur tout ou partie du substrat 110.

Par exemple, la (ou les) couche métallique 120 est une couche mince comprenant du chrome, et/ou de l'aluminium, et/ou du titane. Lorsque plusieurs couches métalliques 120 sont appliquées, celles-ci peuvent être identiques ou différentes.

La (ou les) couche métallique 120 peut être appliquée par un dépôt physique en phase vapeur (PVD) ou par galvanoplastie, par exemple.

Le procédé comprend ensuite l'étape de former un dégradé interférentiel sur la pièce automobile 100, comprenant le dépôt physique en phase vapeur, dans une chambre 200 de dépôt physique en phase vapeur, d'une couche transparente 130 dite interférentielle sur tout ou partie de l'au moins une couche métallique 120 réflective.

La chambre 200 de dépôt physique en phase vapeur comprend, de façon connue, une cible 210 de matériau de base à déposer, un système d'admission de gaz et de contrôle de la pression (non représentés), ainsi qu'un système de mise sous basse-pression ou sous vide (non représenté).

Par exemple, la chambre 200 est une chambre de dépôt physique en phase vapeur de type pulvérisation cathodique, préférentiellement de type pulvérisation cathodique magnétron, bien que d'autres types de chambre de dépôt PVD soient envisageables.

La chambre 200 de dépôt physique en phase vapeur comprend ici une cathode (non représentée), permettant de bombarder avec des ions la cible 210, et ainsi vaporiser le matériau de base pour le déposer sur la pièce automobile 100.

Le dépôt par PVD est un procédé de dépôt de type « à ligne de vue directe » (*lign-of-sight* en terminologie anglaise), c'est-à-dire que seules les parties d'une pièce à revêtir qui sont visibles par la cible sont revêtue de matériau. En d'autres termes, si un obstacle se situe entre la cible et la pièce (l'obstacle pouvant être la pièce elle-même), la partie de la pièce qui est hors de la vue de la cible n'est pas revêtue, les particules de matériau de base vaporisé se déplaçant sensiblement en ligne droite depuis la cible.

Au cours de l'étape de former un dégradé interférentiel, la chambre 200 de dépôt physique en phase vapeur est configurée de manière à ce qu'une partie dite visible de la pièce automobile 100 soit dans la ligne de vue directe de la cible 210, et une partie dite non-visible de la pièce automobile 100 ne soit en permanence pas dans la ligne de vue directe de la cible 210.

La partie non-visible est ainsi une partie qui n'est pas revêtue de la couche transparente 130 interférentielle, car elle n'est pas visible de la cible 210 et ce de manière permanente durant l'étape de former un dégradé interférentiel.

Ladite partie visible quant à elle est revêtue d'une épaisseur de couche transparente 130 interférentielle, étant visible de la cible 210 au moins temporairement durant l'étape de former un dégradé interférentiel.

En outre, une portion dite de dégradé P d'épaisseur variable de la couche transparente 130 interférentielle est formée à la frontière entre la partie visible et la partie non-visible.

Par frontière, on entend une zone délimitant la partie non-visible.

La portion de dégradé P est formée sur une partie visible de la pièce automobile 100, toutefois dans la ligne de vue directe d'une partie seulement de la cible 210. Le fait que la portion de dégradé P ne soit visible que par une partie de la cible entraîne un dépôt moindre de matériau sur cette portion, et forme ainsi une zone de transition d'épaisseur de la couche transparente 130 interférentielle entre la partie visible et la partie non-visible.

Il résulte de cette étape qu'une portion de dégradé P de la couche transparente 130 interférentielle est formée sur la pièce automobile 100, sur laquelle l'épaisseur de la couche transparente 130 interférentielle décroit selon au moins une direction de dégradé X, depuis une zone d'épaisseur supérieure *Zₛ* de la couche transparente 130 interférentielle, qui est formée au niveau de la partie visible, vers une zone d'épaisseur réduite ou nulle *Zᵣ* de la couche transparente 130 interférentielle, qui est formée au niveau de la partie non-visible.

Optionnellement, notamment lorsque la portion de dégradé P doit être formée entre une zone d'épaisseur supérieure *Zₛ* et une zone d'épaisseur réduite, non-nulle, *Zᵣ*, le procédé 300 peut comprendre une étape supplémentaire de premier dépôt physique en phase vapeur d'une première couche transparente interférentielle identique à la couche transparente 130 interférentielle, déposée indifféremment sur tout ou partie de la couche métallique 120.

Le procédé peut enfin comprendre une étape de déposer une couche de finition 150 transparente sur tout ou partie de la pièce automobile, choisie de sorte à préserver les couleurs interférentielles perçues et qui sont obtenues au moyen de la couche transparente 130 interférentielle.

A cet effet, la couche de finition 150 peut être sélectionnée avec un indice de réfraction sensiblement équivalent à l'indice de réfraction de la couche transparente 130 interférentielle.

L'étape de former un dégradé interférentiel est réalisée de façon contrôlée dans le procédé 300, c'est-à-dire que les épaisseurs de la couche transparente 130 interférentielle aux abords de la portion de dégradé P ainsi que la taille de la portion de dégradé P sont prédéterminées, permettant de déterminer précisément l'aspect du décor coloré obtenu.

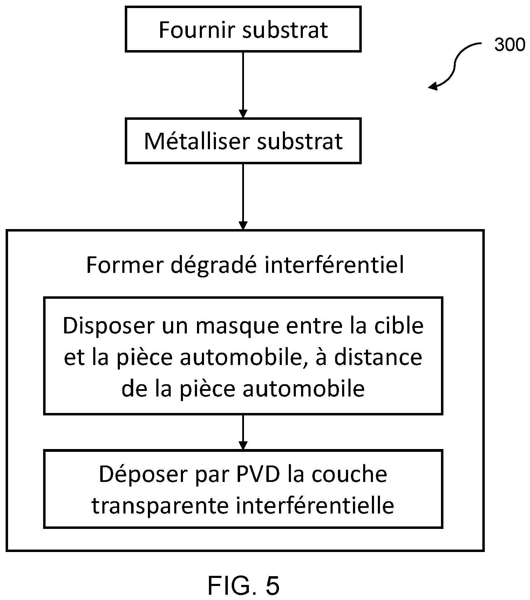

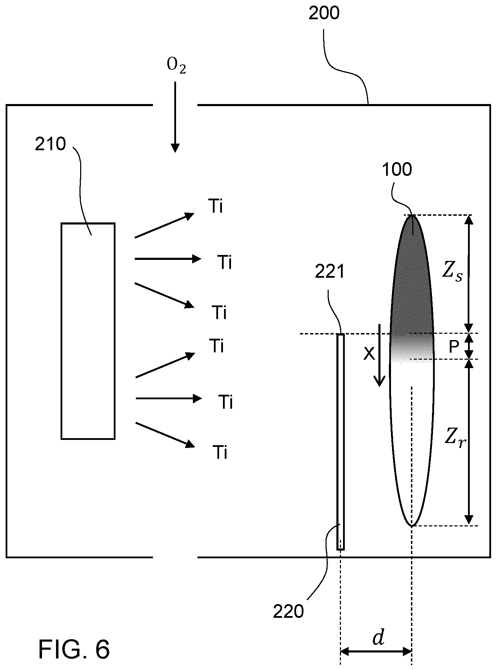

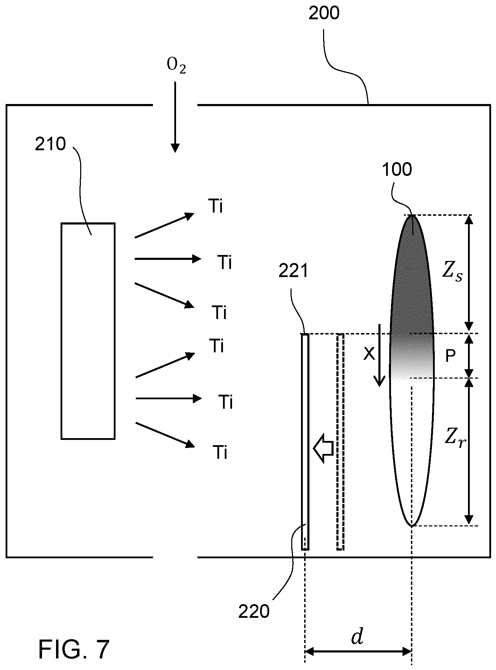

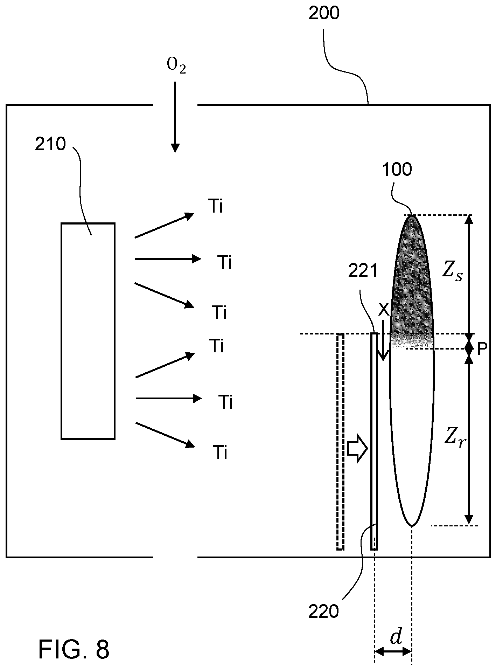

A cet effet, selon un premier mode de réalisation du procédé 300, illustré à la figure 5, et en se référant aux figures 6 à 8 qui illustrent une pièce automobile 100 en cours de traitement dans une chambre de dépôt 200 de dépôt physique en phase vapeur, l'étape de former un dégradé interférentiel comprend la configuration de la chambre 200 de dépôt physique en phase vapeur avec la disposition d'un masque 220 entre la cible 210 de matériau de base à déposer en phase vapeur et la pièce automobile 100.

Il convient de préciser qu'à titre d'illustration uniquement, sur les figures 6 à 8, le matériau de base à déposer est du Titane, et le gaz réactif du dépôt PVD est du dioxygène.

Le masque 220, qui est choisi de sorte à être opaque à la pulvérisation de matériau de base à déposer, par exemple réalisé en matériau métallique tel que l'acier ou l'aluminium, est placé à distance de la pièce automobile 100, c'est-à-dire qu'il n'est pas en contact avec cette dernière.

On précise que le masque peut être réalisé par formage, usinage, découpe d'un matériau métallique, ou tout autre procédé adapté.

Le masque 220 est placé en vis-à-vis de la partie non-visible, de façon à empêcher au moins localement le dépôt de matériau de base sur la pièce automobile 100.

Le masque 220 comprend au moins un bord 221, qui est placé en vis-à-vis de la pièce automobile 100, au niveau d'une zone de la pièce automobile 100 sur laquelle doit être formée la portion de dégradé P.

Lors de la pulvérisation du matériau de base à déposer, les zones du substrat qui sont dans l'ombre du masque 220 par rapport à la cible 210, c'est-à-dire la partie non-visible qui n'est pas dans la ligne de vue directe de la cible 210, ne sont pour pas recouvertes de la couche transparente 130 interférentielle, tandis que celles qui ne sont pas masquées par le masque 220, c'est-à-dire la partie visible qui est dans la ligne de vue directe de la cible 210, sont recouvertes de la couche transparente 130 interférentielle.

Au niveau de la zone du substrat 110 en vis-à-vis du bord 221 du masque 220, l'épaisseur de la couche transparente 130 interférentielle ne passe pas abruptement d'une épaisseur à une autre (ou à une épaisseur nulle), mais de façon progressive.

Ceci est dû au fait qu'une certaine quantité de matériau à déposer parvient aux zones du substrat 110 qui sont « derrière » le masque 220 par rapport à la cible 210, mais qui sont dans la ligne de vue directe d'une partie de la cible 210.

Ceci est rendu possible en raison de la distance du masque 220 par rapport au substrat 110.

On précise que dans l'exemple illustré aux figures 6 à 8, la pièce automobile 100 peut être mobile en rotation autour d'un axe ici sensiblement parallèle à la cible 210, de façon à revêtir entièrement la partie visible (c'est-à-dire ici les zones de la partie visible qui sont en éloignement de la cible 210 sur les figures 6 à 8). La partie non-visible reste hors de la ligne de vue directe de la cible 210 en tout temps malgré une telle rotation.

Ainsi, la portion de dégradé P peut être formée sur la pièce automobile 100en vis-à-vis dudit bord 221 du masque 220 de manière particulièrement commode, tout en étant particulièrement contrôlable.

En effet, la disposition du masque 220 peut se faire à une distance d prédéterminée de la pièce automobile 100, cette distance d prédéterminée déterminant la dimension de la portion de dégradé P dans au moins une direction de dégradé X, qui s'étend entre la partie visible et la partie non-visible.

Ainsi, en rapprochant le masque 220 de la pièce automobile 100, la dimension de la portion de dégradé P est réduite (moins de matière pulvérisée étant susceptible de parvenir « derrière » le masque 220), et en éloignant le masque 220 du substrat 110, la dimension de la portion de dégradé P est augmentée (davantage de matière pulvérisée étant susceptible de parvenir « derrière » le masque 220).

En outre, l'utilisation d'un masque 220 permet de concevoir des motifs colorés de manière particulièrement simple et commode.

A cet effet, l'au moins un bord 221 du masque 220, qui est placé en vis-à-vis du substrat 110, forme un contour d'un motif prédéterminé. Le négatif de ce motif (c'est-à-dire que la couche transparente 130 interférentielle est déposée en dehors de ce motif) est ensuite formé sur la pièce automobile 100 par dépôt de la couche transparente 130 interférentielle.

Selon d'autres exemples non illustrés, le masque 220 peut comporter une ou plusieurs ouvertures délimitant chacune un bord 221, de manière à former des portions de dégradé en forme de boucle fermée.

Par ailleurs, plusieurs portions de dégradé peuvent être adjacentes, de sorte à former une pluralité de dégradés de « sens » opposés à la suite.

De manière générale, le type de masque 220, leur nombre et leur arrangement par rapport au substrat 110 peuvent être variés et combinés librement afin d'obtenir le décor métallique souhaité sur la pièce automobile 100.

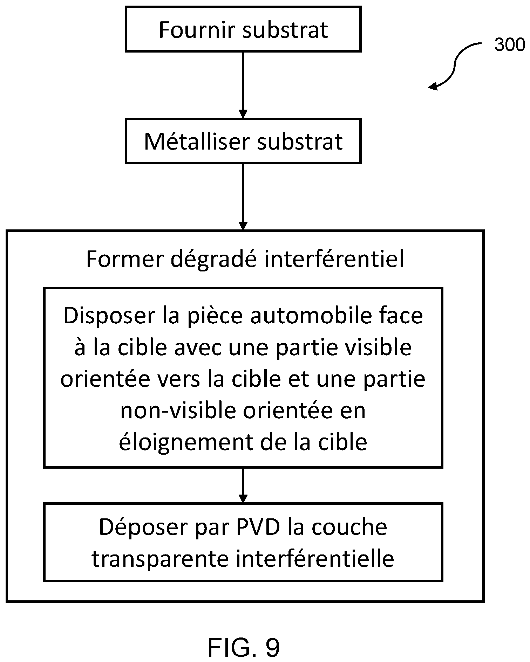

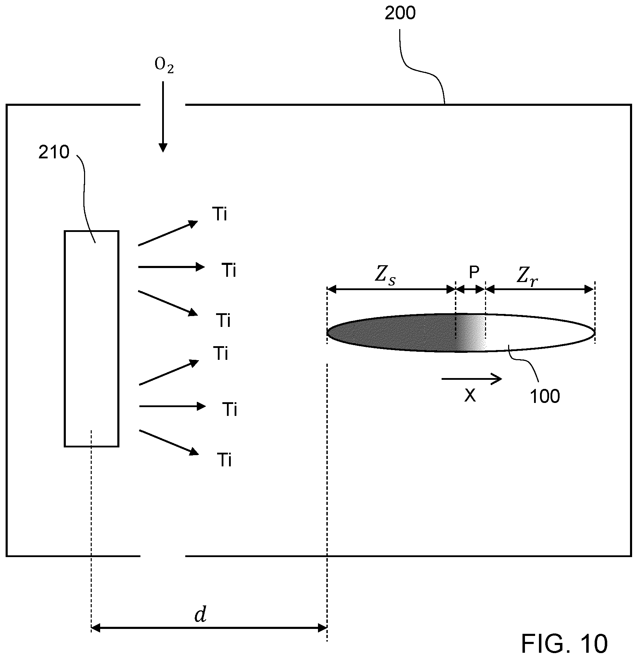

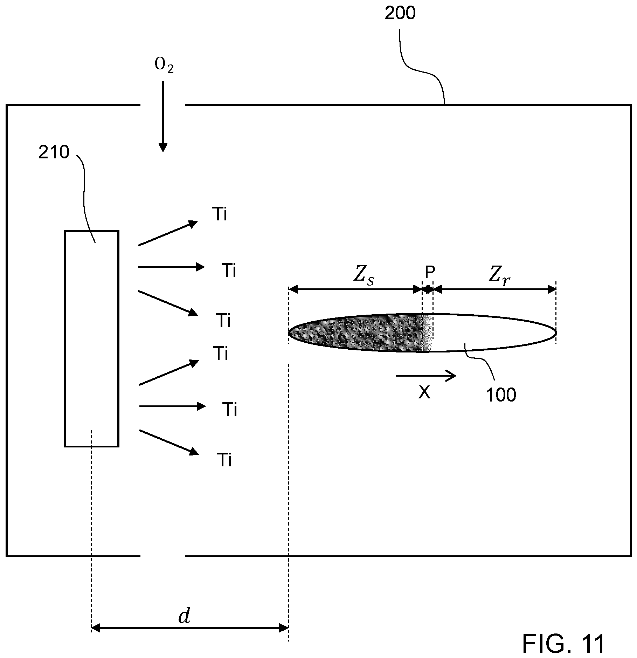

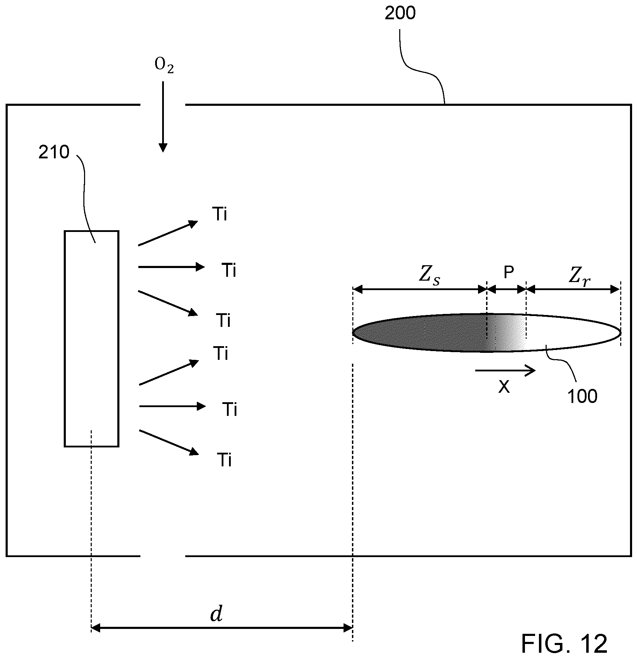

En outre, selon un deuxième mode de réalisation du procédé 300, illustré à la figure 9, et en se référant aux figures 10 à 12 qui illustrent un substrat 110 en cours de traitement dans une chambre de dépôt 200 par phase physique vapeur, l'étape de former un dégradé interférentiel peut être réalisée sans nécessiter de masque.

A cet effet, la chambre 200 est configurée avec la pièce automobile 100 qui est disposée de sorte que la partie visible soit orientée vers à la cible 210 et la partie non-visible soit orientée en éloignement de la cible 210.

La partie de la pièce automobile 100 orientée vers la cible 210 (c'est-à-dire dont la normale à la surface est dirigée comprend une composante dirigée vers la cible 210) est visible de la cible 210 et reçoit du matériau de base à déposer.

La partie de la pièce automobile 100 orientée en éloignement de la cible 210 (c'est-à-dire dont la normale à la surface est dirigée comprend une composante en éloignement de la cible 210) n'est pas visible de la cible 210 et ne reçoit pas de matériau de base à déposer.

La portion de dégradé P est formée à la frontière entre les parties visibles et non-visible.

Dans ce mode de réalisation également, la dimension de la portion de dégradé P peut être contrôlée, toutefois ici en ajustant directement la distance d séparant la pièce automobile 100 et la cible 210, et/ou à l'orientation par rapport à cette dernière.

A cet effet, la pièce automobile 100 est disposée à une distance d prédéterminée de la cible 210 et/ou avec une orientation *α* prédéterminée par rapport à la cible 210, cette distance et/ou orientation déterminant la dimension de la portion de dégradé P dans au moins une direction de dégradé X entre la partie visible et la partie non-visible.

Comme cela est visible sur les figures 10 à 12, plus la pièce automobile 100 est éloigné de la cible 210, plus la dimension de la portion de dégradé P selon la direction de dégradé X est importante, et inversement.

Il convient de remarquer qu'en comparaison avec le mode de réalisation du procédé 300 illustré aux figures 6 à 8, l'orientation de la pièce automobile 100 est ici sensiblement pivotée à 90° pour toutefois obtenir un décor métallisé similaire. Bien entendu, de façon générale, l'orientation nécessaire dépend de la forme de la pièce à décorer.

De façon similaire, plus une face de la pièce automobile 100 est orientée avec sa normale dirigée dans la direction de la cible 210, plus cette face comportera une portion de dégradé importante, jusqu'à ne comporter aucun dégradé mais uniquement une zone d'épaisseur sensiblement uniforme.

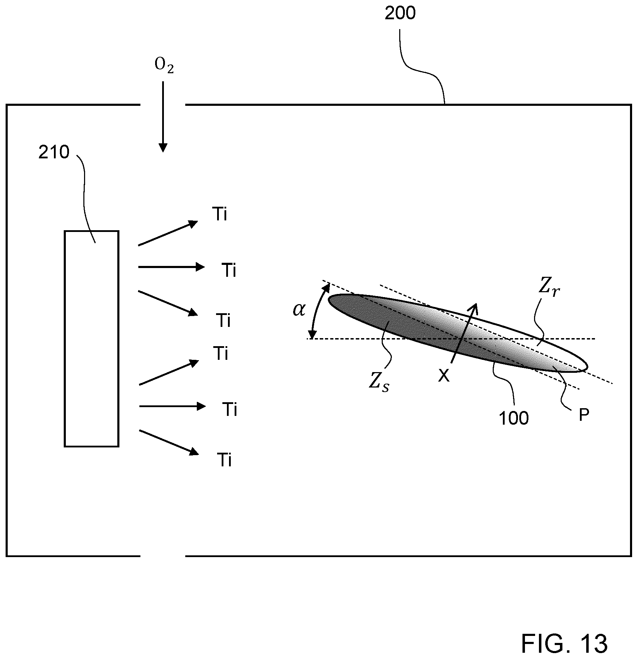

La figure 13 illustre la pièce automobile 100 avec une orientation différente de celle des figures 10 à 12, où la pièce automobile 100 a été pivotée d'un angle *α*.

La taille et la position du dégradé interférentiel peut être contrôlé en ajustant l'angle d'inclinaison *α* de la pièce automobile 100.

Bien entendu, le contrôle de la distance tel que sur les figures 10 à 12 ainsi que le contrôle de l'orientation tel que sur la figure 13 peuvent être réalisés simultanément afin d'obtenir l'aspect du dégradé interférentiel souhaité.

Quel que soit le mode de réalisation du procédé 300, le matériau de base à déposer (c'est-à-dire le matériau de base de la cible 210) peut être choisi parmi le titane (Ti), le zirconium (Zr), le chrome (Cr), le silicium (Si), le cuivre (Cu), l'aluminium (Al), le nickel (Ni), le magnésium (Mg), le tantale (Ta), le hafnium (Hf) ou le carbone type diamant (DLC).

De préférence, le dépôt physique en phase vapeur pour former un dégradé interférentiel est de type pulvérisation cathodique, et préférentiellement de type pulvérisation cathodique magnétron.

Le dépôt physique en phase vapeur peut également être de type arc-PVD (standard, ou basse température LTAVD), de type évaporation (« Thermique » ou dite « E-beam »), de type ablation laser pulsé (PLD), et de type dépôt chimique en phase vapeur assisté par plasma (PECVD), notamment pour le dépôt de DLC.

De préférence également, le dépôt physique en phase vapeur est un dépôt physique en phase vapeur dit réactif, réalisé en présence d'une quantité prédéterminée de gaz réactif, par exemple du dioxygène (O2) ou du diazote (N2), et d'une quantité prédéterminée de gaz porteur, par exemple de l'argon (Ar).

Un tel dépôt permet d'obtenir une couche transparente interférentielle de stoechiométrie prédéterminée, ce qui a pour effet de déterminer la couleur perçue au niveau de la zone d'épaisseur supérieure *Zₛ*.

La couche transparente 130 interférentielle ainsi formée peut par exemple être du dioxyde de titane (TiO2), du dioxyde de zirconium (ZrO2), du dioxyde de chrome (CrO2), du nitrure de silicium (Si3N4), du carbone type diamant (DLC), du nitrure de titane (TiN), de l'oxynitrure de titane (TiNxOy), ou du silicium (Si), selon l'association matériau de base/gaz réactif.

En outre, la pulvérisation en mode dit réactif permet de maîtriser l'empoisonnement de la cible de matériau de base à déposer.

Lorsque la pulvérisation cathodique est réalisée par une alimentation en courant direct (DC), le réglage de paramètres de pulvérisation et le positionnement de la pièce automobile 100 dans la chambre 200 de dépôt physique en phase vapeur permet d'éviter tout empoisonnement de la cible.

Lorsque la pulvérisation cathodique est réalisée en courant direct (DC) pulsé, ou RF, le dépôt PVD peut être réalisé malgré un empoisonnement au niveau de la cible.

Plus généralement, pour un dépôt physique en phase vapeur de type pulvérisation cathodique (magnétron ou non), l'alimentation peut être de type MF, RF, DC, DC pulsée, ou encore de type HiPIMS.

De préférence, lorsqu'un effet d'iridescence important est souhaité, une épaisseur faible, par exemple inférieure à 50 nanomètres, de la couche transparente 130 interférentielle peut être choisie. Ainsi, la couleur perçue par interférence varie très fortement même en cas de variation faible de l'angle d'observation de la pièce automobile 100.

On rappelle plus généralement que l'invention ne se limite pas aux exemples décrits et représentés.

En particulier, le procédé et la pièce qui sont décrits ci-avant peuvent être également mis en oeuvre dans des domaines différents du domaine automobile, sans modifications substantielles du procédé.

Par exemple, le procédé décrit ci-avant peut être mis en oeuvre pour produire :
- une pièce aéronautique, nautique, ou de tout autre véhicule. Il peut en particulier s'agir d'une pièce de décor, par exemple intérieure, d'un avion, d'un bateau ou de tout autre véhicule ;
- une pièce d'un appareil électroménager (lave-linge, four, sèche-cheveux, lisseur à cheveux, etc.), de cuisine (robot pâtissier, mixeur, etc.), électronique (modem, décodeur de télévision, console de jeux, ordinateur, téléphone mobile, etc.) ;
- une pièce de type contenant, par exemple cosmétique (flacon, pot, boîtier pour maquillage, etc.), ou encore alimentaire (bouteille, boîte, etc.).

Plus généralement, le procédé peut être mis en oeuvre sur tout substrat de pièce en matière plastique.

## Revendications

1. Procédé (300) d'application d'un décor métallique sur un substrat (110) de pièce automobile (100) en matière plastique, comprenant les étapes de :
- fournir un substrat (110) de pièce automobile (100) en matière plastique ;
- métalliser au moins partiellement le substrat (110) par dépôt d'au moins une couche métallique (120) dite réflective sur tout ou partie du substrat (110) ; **caractérisé en ce que** le procédé (300) comprend en outre l'étape de :
- former un dégradé interférentiel sur la pièce automobile (100), comprenant le dépôt physique en phase vapeur, dans une chambre (200) de dépôt physique en phase vapeur, d'une couche transparente (130) dite interférentielle sur tout ou partie de l'au moins une couche métallique (120) réflective, ladite chambre (200) étant configurée de manière à ce qu'une partie dite visible de la pièce automobile (100) soit dans la ligne de vue directe d'une cible (210) de matériau de base à déposer en phase vapeur, et une partie dite non-visible de la pièce automobile (100) ne soit en permanence pas dans la ligne de vue directe de ladite cible (210), de sorte que ladite partie visible est revêtue d'une épaisseur de couche transparente (130) interférentielle et ladite partie non-visible n'est pas revêtue de couche transparente (130) interférentielle, et une portion dite de dégradé (P) d'épaisseur variable de la couche transparente (130) interférentielle est formée à la frontière entre ladite partie visible et ladite partie non-visible, grâce à quoi le décor métallique comporte un dégradé interférentiel qui présente un aspect coloré lorsque le décor métallique est exposé à la lumière.

2. Procédé (300) selon la revendication 1, dans lequel la chambre (200) de dépôt physique en phase vapeur est configurée avec un masque (220) qui est disposé à distance de la pièce automobile (100) entre la cible (210) et la pièce automobile (100), le masque (220) étant placé en vis-à-vis de ladite partie non-visible, et au moins un bord (221) du masque (220) étant placé en vis-à-vis de pièce automobile (100), de façon à former ladite portion de dégradé (P) sur la pièce automobile (100) en vis-à-vis dudit bord (221) du masque (220).

3. Procédé (300) selon la revendication 2, dans lequel le masque (220) est disposé à une distance (d) prédéterminée de la pièce automobile (100), cette distance (d) prédéterminée déterminant la dimension de ladite portion de dégradé (P) dans au moins une direction de dégradé (X) s'étendant entre la partie visible et la partie non-visible.

4. Procédé (300) selon l'une quelconque des revendications 2 ou 3, dans lequel l'au moins un bord (221) du masque placé en vis-à-vis de pièce automobile (100) forme un contour d'un motif prédéterminé, de manière à former le négatif dudit motif sur la pièce automobile (100) par dépôt de la couche transparente (130) interférentielle.

5. Procédé (300) selon la revendication 1, dans lequel la chambre (200) de dépôt physique en phase vapeur est configurée avec la pièce automobile (100) qui est disposée dans la chambre (200) de dépôt physique en phase vapeur de sorte que la partie visible soit orientée vers la cible (210) et la partie non-visible soit orientée en éloignement de la cible (210).

6. Procédé (300) selon la revendication 5, dans lequel la pièce automobile (100) est disposée à une distance (d) prédéterminée de la cible (210) et/ou avec une orientation (*α*) prédéterminée par rapport à la cible (210), cette distance prédéterminée (d) et/ou orientation (*α*) prédéterminée déterminant la dimension de la portion de dégradé (P) dans au moins une direction de dégradé (X) s'étendant entre la partie visible et la partie non-visible.

7. Procédé selon l'une quelconque des revendications 1 à 6, dans lequel lors de l'étape de former un dégradé interférentiel, la couche transparente interférentielle (130) est déposée sur une épaisseur prédéterminée au niveau de la partie visible, cette épaisseur prédéterminée déterminant la couleur perçue par interférence optique au niveau de la partie visible ainsi qu'au niveau de la portion de dégradé (P).

8. Procédé (300) selon l'une quelconque des revendications 1 à 7, dans lequel lors de l'étape de former un dégradé interférentiel, le matériau de base à déposer est choisi parmi le titane (Ti), le zirconium (Zr), le chrome (Cr), le silicium (Si), le cuivre (Cu), l'aluminium (Al), le nickel (Ni), le magnésium (Mg), le tantale (Ta), le hafnium (Hf) ou le carbone type diamant (DLC).

9. Procédé (300) selon l'une quelconque des revendications 1 à 8, dans lequel le dépôt physique en phase vapeur est de type pulvérisation cathodique, préférentiellement de type pulvérisation cathodique magnétron.

10. Procédé (300) selon l'une quelconque des revendications 1 à 9, dans lequel le dépôt physique en phase vapeur est un dépôt physique en phase vapeur dit réactif, réalisé en présence d'une quantité prédéterminée de gaz réactif et d'une quantité prédéterminée de gaz porteur, permettant d'obtenir une couche transparente interférentielle de stoechiométrie prédéterminée déterminant la couleur perçue au niveau de la partie visible.

11. Procédé (300) selon la revendication 10, dans lequel le gaz réactif est du dioxygène (O2) ou du diazote (N2).

12. Procédé (300) selon l'une quelconque des revendications 1 à 11, dans lequel l'étape de métalliser le substrat est réalisé par dépôt physique en phase vapeur ou par métallisation galvanique.

13. Procédé selon l'une quelconque des revendications 1 à 12, comprenant en outre l'étape de :
- déposer une couche de base (140) sur tout ou partie du substrat (110) en matière plastique, préalablement à l'étape de métalliser le substrat ;
la couche de base (140) étant sélectionnée de sorte à promouvoir l'adhérence de l'au moins une couche métallique (120) réflective sur le substrat (110) ;
et/ou l'étape de :
- déposer une couche de finition (150) transparente sur tout ou partie de la pièce automobile, suite à l'étape de former un dégradé interférentiel,
la couche de finition (150) étant sélectionnée avec un indice de réfraction sensiblement équivalent à l'indice de réfraction de la couche transparente interférentielle (130).

14. Pièce automobile (100) comportant un décor métallique avec un dégradé interférentiel, comprenant :
- un substrat (110) en matière plastique ;
- au moins une couche métallique (120) dite réflective déposée sur au moins une partie du substrat (110) ;
**caractérisée en ce que** la pièce automobile (100) comprend en outre :
- une couche transparente dite interférentielle (130) déposée sur tout ou partie de l'au moins une couche métallique (120) réflective ;
la couche transparente interférentielle (130) comportant une zone d'épaisseur supérieure (Zs), une zone d'épaisseur réduite ou nulle (Zr) de la couche transparente interférentielle, et une portion dite de dégradé (P) sur laquelle l'épaisseur de la couche transparente interférentielle (130) décroit strictement selon au moins une direction de dégradé (X), depuis la zone d'épaisseur supérieure (Zs) jusqu'à la zone d'épaisseur réduite ou nulle (Zr) de la couche transparente interférentielle, grâce à quoi le décor métallique comporte un dégradé interférentiel qui présente aspect coloré lorsque le décor métallique est exposé à la lumière.

15. Pièce automobile (100) selon la revendication 14, dans lequel la couche transparente interférentielle (130) est une couche mince de dioxyde de titane (TiO2), de dioxyde de zirconium (ZrO2), de dioxyde de chrome (CrO2), de nitrure de silicium (Si3N4), de carbone type diamant (DLC), de nitrure de titane (TiN), d'oxynitrure de titane (TiNxOy), ou de silicium (Si).

16. Pièce automobile (100) selon l'une quelconque des revendications 14 ou 15, dans lequel la couche métallique (120) est une couche mince comprenant du chrome, et/ou de l'aluminium, et/ou du titane.

17. Pièce automobile (100) selon l'une quelconque des revendications 14 à 16, dans lequel le substrat (110) en matière plastique est en polycarbonate (PC), en polypropylène (PP), en acrylonitrile butadiène styrène (ABS) ou en mélange polycarbonate-acrylonitrile butadiène styrène (PC-ABS).

18. Pièce automobile (100) selon l'une quelconque des revendications 14 à 17, dans lequel l'épaisseur de la zone d'épaisseur supérieure (Zs) de la couche transparente interférentielle (130) est comprise entre 10 et 400 nanomètres, préférentiellement comprise entre 10 et 300 nanomètres, et encore plus préférentiellement comprise entre 10 et 100 nanomètres.

19. Véhicule automobile comportant une pièce automobile (100) selon l'une quelconque des revendications 14 à 18.
